Europäisches Patentamt

European Patent Office

Office européen des brevets

(19)

(11) Publication number: **0 177 653**
A1

# (12) EUROPEAN PATENT APPLICATION

(21) Application number: **84402032.1**

(22) Date of filing: **10.10.84**

(51) Int. Cl.⁴: **H 03 M 1/06**

(43) Date of publication of application: **16.04.86**
Bulletin 86/16

(84) Designated Contracting States: **DE FR GB IT NL**

(71) Applicant: **FAIRCHILD CAMERA & INSTRUMENT
CORPORATION, 464 Ellis Street, Mountain View
California 94042 (US)**

(72) Inventor: **Sloane, Edwin A., 1040 Covington Road, Los
Altos California 94022 (US)**

(74) Representative: **Chareyron, Lucien et al, Schlumberger
Limited Service Brevets c/o Giers 12, place des Etats
Unis B.P. 121, F-92124 Montrouge Cédex (FR)**

(54) Apparatus for compensating digital to analog converter errors.

(57) A high precision digital to analog converter comprises
the combination of an imperfect or low resolution digital to
analog converter having an error function known in terms
of orthonormal components and an error compensating
device capable of generating correction terms which do not
interact with one another. The correction terms are based
on orthonormal components namely, the Walsh function
components, of each signal level to be compensated. At
most only one weighting value per bit is required, the com-
bination of which will compensate for errors of any bit
combination. In a specific embodiment employing feedfor-
ward compensation, the output of the low resolution con-
verter and of the compensating device may be summed to
produce a high performance, high precision converter with
increased accuracy and resolution. In other specific em-
bodiments, the compensating device responds to selected
digital bit inputs to produce an analog output which is sum-
med at an intermediate summing junction with the analog
signal of the converter.

APPARATUS FOR COMPENSATING
DIGITAL TO ANALOG CONVERTER ERRORS

Background of the Invention

1.    Field of the Invention

This invention relates to digital electronic converters and particularly to methods and apparatus for converting digital signals into analog signals.

Converters between digital and analog domains are employed to interface between digital electronic circuitry and devices requiring analog signals. Accuracy of conversion, gain and repeatability in the process of conversion are matters of concern which are important to evaluate and for which compensation is frequently required.

Precision converters are needed for critical conversion applications. However, precision converters are generally expensive and difficult to implement. Reasonably cost, commercial quality converters frequently suffer from errors in conversion which render them unusable for critical applications. What is needed is a technique for increasing the accuracy of reasonably reliable commerically available converters so they can be used even in critial applications.

2.   Description of the Prior Art

Trimming techniques for analog to digital and digital to analog converters have been suggested for limited purposes. For example, L.F. Pau, "Fast Testing and Trimming of A/D and D/A Converters in Automatic Test Systems", 1978, IEEE Auto Test Conference, has suggested a method for trimming converters based on the use of Walsh functions. A more generalized proposal for correction of converter errors based on Walsh functions is described in J.T. Millman, "Error Minimization of Data-Converting Systems via Generalized Spectral Analysis," Ph.D. Thesis, Massachusetts Institute of Technology, submitted August 21, 1975 (available October 27, 1975). Specifically, Millman suggests the use of on-the-converter error-correction circuitry employing Walsh functions which can be generated through the use of EXCLUSIVE OR functions under control of a programmable read only memory. Millman suggests incorporation of correction circuitry into the original design and layout of a digital to analog converter and specifically the provision of fine control of the current-setting resistor internal to the digital to analog converter. However, Millman recognized the infeasibility of implementing on-the-converter correction circuitry for any interactive Walsh function errors in existing circuitry. Millman's work has been limited to internal compensation and has made no suggestion for alternative solutions.

Intersil, Inc. of Cupertino, California manufactures a correcting digital to analog converter device under the trade name ICL 7134. The ICL 7134 is a multiplying digital to analog converter which has a programmable read only memory array for controlling a

- 3 -

0177653

12 bit correcting digital to analog converter in the same device. The structure allows for modulo-32 cyclical corrections to be applied to the signal output. However, with the Intersil device, it is very difficult to correct for no-linearities in the analog output because all digital input functions are inter-related. Furthermore,, only a group of the most significant bits are used for error correction so that significant errors involving the lower significant bits are potentially ignored.

## Summary of the Invention

It is a general object of the present invention to provide an improved apparatus for converting a digital signal input into an analog signal output.

This and other objects are attained, in accordance with one aspect of the invention, by an apparatus for converting a digital input signal to an analog output signal comprising a digital to analog converter device having an analog signal conversion error responsive to said digital input signal to produce an analog output signal, said conversion error being known in terms of orthonormal components of the input signal; a signal error compensating device for producing a compensating signal specific to said conversion error and non-interacting with said digital to analog converter; and means for correcting said analog output signal with said compensating signal to produce a compensated analog output signal.

Another aspect includes an apparatus for converting a digital input signal to an analog output signal comprising a digital to analog converter device having an analog signal conversion error for producing an analog intermediate signal, said conversion error being known in terms of orthonormal components of the input signal; an analog signal error compensating device responsive to said digital signal for producing an analog compensating signal specific to said conversion error and non-interacting with said digital to analog converter; and means for summing said analog intermediate signal and said analog compensating signal to produce said analog output signal.

- 4 -

0177653

The invention will be better understood by reference to the following detailed description taken in connection with the accompanying drawings.


## Brief Description of the Drawings

FIG. 1 is a block diagram of a device according to the invention wherein feedforward pre-correction is employed.

FIG. 2 is a block diagram of the invention wherein serial pre-correction is employed.

FIG. 3 is a block diagram of the invention wherein serial post-correction is employed.

FIG. 4 is a block diagram of the invention wherein feedback correction is employed.

FIG. 5 is a block diagram of a specific embodiment of a feedforward correction network according to the invention.

FIG. 6 is a block diagram of a second specific embodiment of the invention wherein feedforward correction is employed.

FIG. 7 is a block diagram of a specific embodiment of the invention wherein serial pre-correction is employed.


## Description of Specific Embodiments

It is known that Walsh functions are well suited to the representation of memoryless transfer characteristics of mixed signal devices such as digital to analog converters. This is because the Walsh functions form a complete set of orthogonal two-state functions capable of representing any reasonable function spanning a multiple of a binary number of intervals. As a consequence, all compensating functions based on the orthogonal binary functions are independent of one another and hence do not interact in any potential adjustment or correction scheme. However, Walsh functions are but one example of an orthonormal set of digital function upon which correction signals may be based. Reference is made to E.P.O. Patent Appln. No. 81401721.6. for a discussion of such functions.

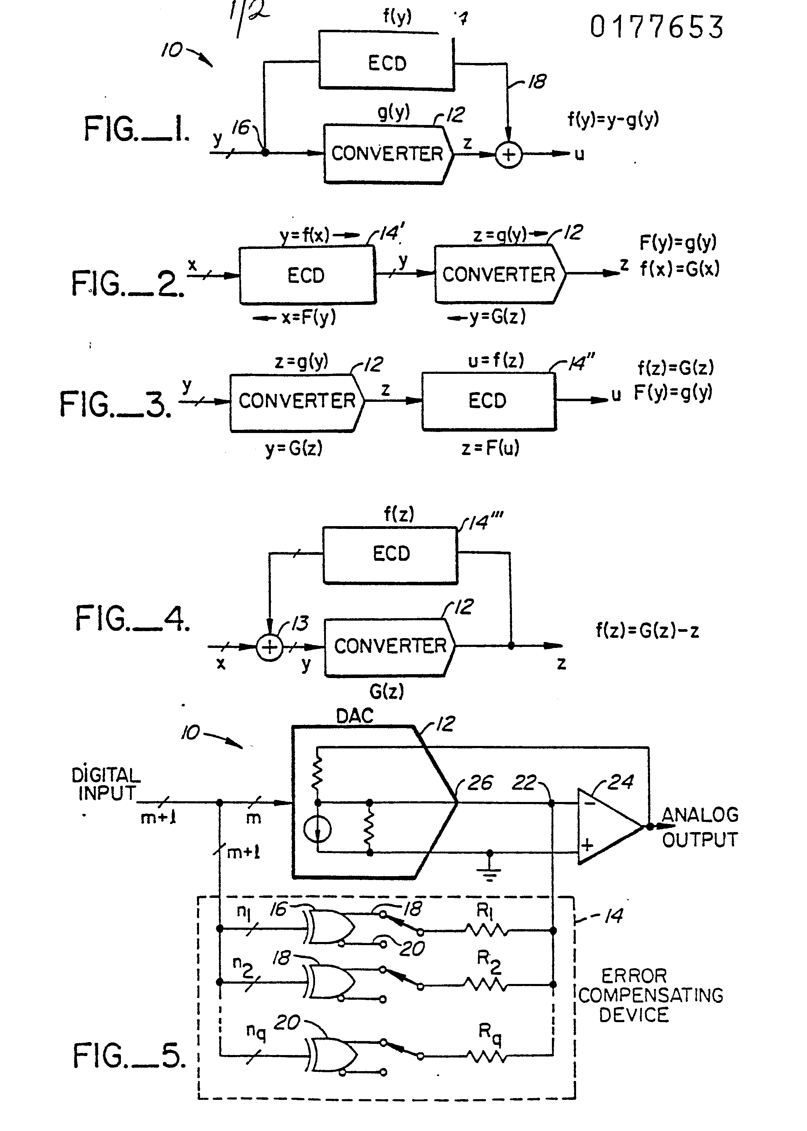

Referring to FIG. 1, there is shown one embodiment of a digital to analog converter system 10 according to the invention comprising a digital to analog converter 12 having a known error characteristic or error function and a compensating device 14. The compensating device 14 responds to the same digital input at an input node 16 as the converter 12 and produces an analog output on an analog signal line 18 as an analog compensating signal. The function of the converter 12 may be expressed as $g(y)$ which produces an analog intermediate signal z in response to a digital input signal y. The error compensating device 14 may be expressed as a function $f(y)$. The function $f(y)$ is specifically tailored to produce a value equal to the value $y-g(y)$ expressed in analog terms at its output. The sum of the analog correction signal and the analog intermediate signal is a value u which is the desired output signal in analog form. The u valued signal in a properly designed system 10 is a properly scaled analog equivalent of the digital input y.

Referring to FIG. 2, there is shown another possible configuration for an apparatus according to the invention.

In this embodiment a signal x is applied to an error compensating device 14' which produces an output signal y which is a function of f(x) which in turn is applied to a converter 12 having a function g(y) to produce an analog output z. This scheme is called serial pre-correction. Since the value x is the digital equivalent of the analog value z, the inverse transform of the error compensating device 14' is equal to the forward transfer function g(y) of the converter 12. Also the forward function f(x) of the error compensating device 14' is equal to the inverse transfer function G(x) of the converter 12.

FIG. 3 illustrates serial post-correction wherein the converter 12 applies its analog output z to an error compensating device 14". In this case, the forward function of the error compensating device 14" f(z) is equal to the reverse function G(z) of the converter 12, and the reverse function F(y) of the error correcting device 14" is equal to the forward function g(y) of the converter 12.

FIG. 4 illustrates a feedback technique for correcting converter output. The error compensating device 14''' receives as an analog input the output of the converter 12 and provides a digital output to a digital adder 13. The adder 13 adds a digital signal to the digital input signal, the sum of which is applied to the input of the converter 12. In feedback techniques, the digital input signal x is equal to the analog output signal z if the reverse function G(z)-z of the converter 12 is equal to the forward function f(z) of the error compensating device 14''' so that the value y at the input to the converter 12 is equal to the sum of the value x and the value f(z). The function of the error compensating network 14''' is the difference between the converters inverse characteristic and the ideal linear characteristic.

Either the forward transfer characteristic of the converter 12 or the inverse function of the converter 12 must be known before compensation may be applied. The forward transfer characteristic may be obtained by uniformly varying the input to the device and observing the response to which Walsh domain filtering may be applied.

The inverse function may be obtained by using a uniformly distributed input function, y, so that:

$$p(y) = \frac{1}{Y}$$

And noting that the density function of the response function is:

$$p(z) = p(y) \frac{dy}{dz} = \frac{1}{Y} G'(z)$$

so that

$$G(z) = Y \int p(z) dz$$

In the case of ADC, G(z) might also be obtained by means of exponential excitation as described in E.P.O. Patent Appln. No. 81.401721.6.

Each of the compensating methods have preferred applicability to either ADC's or DAC's depending on the availability of the digital code. Consider for instance, the following input/output relationship:

$$z = g(y) = g(n y_o) = g(n)$$

Where the input, y, is uniformly quantized with increments of $y_o$. In terms of the Walsh functions:

$$z = \sum_{k=0}^{2^m-1} g_k \cdot \psi_k(n) \, , \quad 2^m y_o = 1$$

where

$$g_k = \sum_{n=o}^{N-1} g(n) \cdot \Psi_k(n)$$

The output, z, at any given quantized input state, n, will be the weighted sum of all the significant Walsh terms. The set of weights, ($g_k$), will be either added or subtracted depending on the sign of the Walsh functions, {$\Psi_k(n)$}, at state n. Because the state of the binary order Walsh functions, {$\Psi_{2^\ell}(n)$}, is known from the input state n, i.e., the corresponding binary input code indicates the sign of the binary ordered functions, the sign of any other (non-binary) Walsh function may be determined by means of the generating rule. Thus;

$$\Psi_{k\Theta\ell}(n) = \Psi_k(n) \cdot \Psi_\ell(n)$$

If k ≠ ℓ and both are of binary order,

$$\Psi_{k+\ell}(n) = \Psi_k(n) \cdot \Psi_\ell(n)$$

And the sign (signum) of the resultant will be;

$$sgn\,\{\Psi_{k+\ell}(n)\} = sgn\,\{\Psi_k(n)\} \cdot sgn\,\{\Psi_\ell(n)\}$$

In general, the sign will be the product of the appropriate binary ordered Walsh functions which are determined by the binary code of the input state n.

The equivalent logical operation based on the logical (on-off) representation of the Walsh functions is:

$$\overline{\phi}_{k\Theta1}(n) = \phi_k(n) \; \Theta \overline{\phi}_\ell(n)$$

Where $\Theta$ represents the EOR operation, and $\overline{\phi}$ is the logical complement of $\phi$. The availability of

quantized data is an important consideration in the selection of a correction scheme for a digital to analog converter. A digital to analog converter has quantized inputs. Hence the methods of FIG. 1, feed forward correction, and of FIG. 2, serial pre-correction, are best suited for applications with digital to analog converters.

FIG. 5 illustrates a specific embodiment for a digital to analog converter device 10 having feed forward correction. In FIG. 5, a converter 12 is fed by $m + \ell$ bits of information, m bits of which are applied to the converter 12 and the $m + \ell$ bits being applied to the error compensating device 14. The error compensating device 14 comprises a plurality of EXCLUSIVE OR gates 16, 18, 20, for example, each receiving a different set of digital input bit lines $n_1, n_2 \, n_q$ of the $m + \ell$ input signals. The exact input bit line configuration is defined by the orthogonal components of error function associated with the converter 12. Each EXCLUSIVE OR gate 16, 18, 20 for example, EXCLUSIVE OR gate 16, is provided with TRUE input states on signal line set $n_1$ of one level to be corrected. The weighting of the signal line set is either added or subtracted (as indicated by alternative outputs of 18, 20 of EXCLUSIVE OR gate 16), and the magnitude of the weighting is defined by a resistance of the corresponding EXCLUSIVE OR gate. $R_1$ corresponds to gate 16, $R_2$ corresponds to gate 18, and $R_q$ corresponds to gate 20. In the specific embodiment, the EXCLUSIVE OR gates 16, 28, 20 are each devices having an output suitable for driving the corresponding output resistor. The output resistors are in turn all coupled to summing junction 22 on an operational amplifier 24 with the output 26 of the converter 12. Whenever any one of the EXCLUSIVE OR gate outputs is true, an analog signal is generated representing the corresponding orthogonal component of the input digital signal. The analog signals add at the summing junction. The analog output of the operational amplifier 24 is the desired corrected analog output.

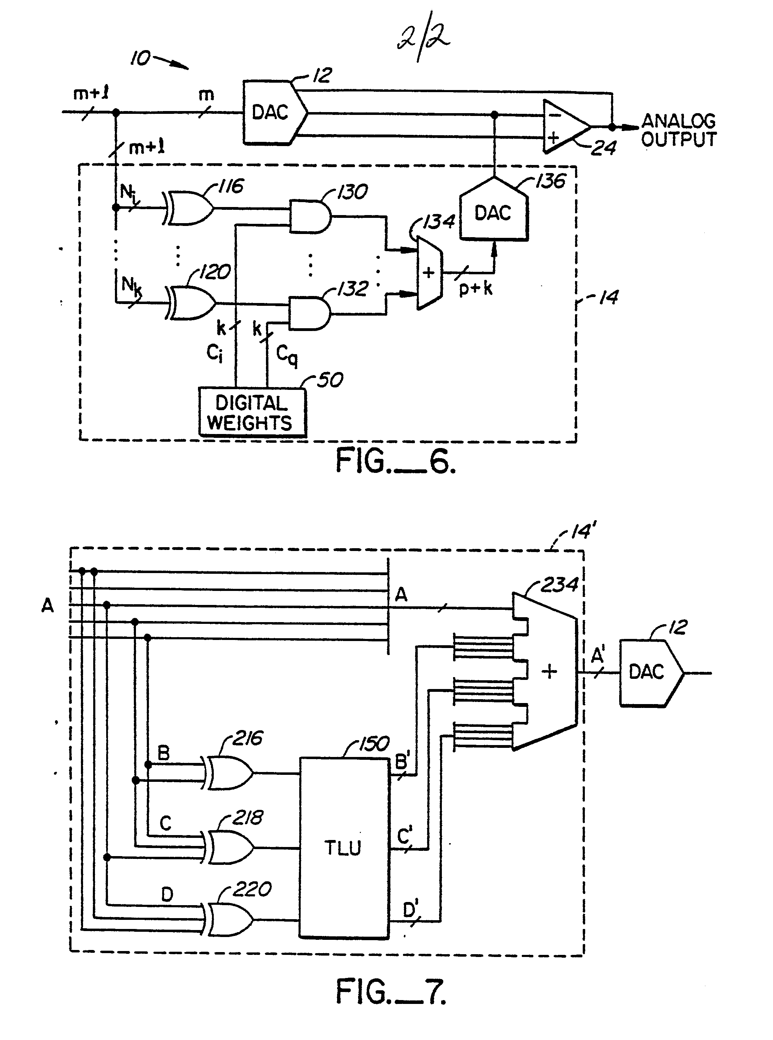

FIG. 6 illustrates a digital to analog converter device 10 with an alternative feed forward scheme using an error compensating device 14 with digital weighting. In this instance, EXCLUSIVE OR gates 116, 120 receive inputs as in FIG. 5, and the outputs thereof are applied to AND gates 130, 132. Each of the AND gates 130, 132 receives a pre-set digital input from a table look-up device 50. The outputs of the AND gates 130, 132 are all applied to a digital adder 134 so as to add, digitally, the weights for the corresponding input state. The output of the adder 34 is applied to a correcting digital to analog converter 136 forming a part of the error compensating device 114. The output of the correcting converter 136 is added to the output of the converter 12 at a summing junction of op amp 24. The analog output of the op amp 24 is the desired compensated output signal.

Pre-serial correction is best implemented in digital form. In FIG. 7, an error compensating device 14' receives a digital signal input A and provides a corrected digital signal output A' to the converter 12 to be compensated. EXCLUSIVE OR gates 216, 218, 220 receive selected inputs of bit sets B, C, D, of the input signal A and apply outputs to a table look-up device (TLU) 150 to produce weighted outputs B' C' and D' in accordance with the invention. The values A, B', C' and D' are added together at a digital adder 234 to produce the corrected digital output A' for application to the converter 12. The output of the converter 12 is the desired analog output signal.

The invention has now been explained with reference to the specific embodiments. Other embodiments will be apparent to those of ordinary skill in the art. For example, one of the advantages of a correction network as shown herein is that no more than one weighting factor per bit is required, since each weighting factor is determined by an analysis of the orthonormal characteristics of that bit with respect to all other bits. Simple EXCLUSIVE OR logical correcting networks have been found to require normally only pairs of input data bits, and generally 0, 1, 2 or 3 combinations of input bits for purposes of correction. Large complex networks are thus unnecessary, and correction networks can be incorporated into devices easily coupled together with ordinary digital to analog converters. Variable resistors may be used for weighting, the adjustments of which can be made empirically, based on an error function analysis by orthonormal components of the converter to be corrected. It is therefore not intended that this invention be limited except as indicated by the appended claims.

CLAIMS:

1.    An apparatus for converting a digital input
signal to an analog output signal characterized by:
        a digital to analog converter device having an
analog signal conversion error responsive to said digital
input signal to produce an analog output signal, said
conversion error being known in terms of orthonormal
components of the input signal;
        a signal error compensating device for producing
a compensating signal specific to said conversion error
and non-interacting with said digital to analog converter;
and
        means for correcting said analog output signal
with said compensating signal to produce a compensated
analog output signal.

2.    The apparatus according to claim 1 characterized
in that said error compensating device is operative to
generate an analog error compensating signal from Walsh
function components of said digital input signal.

3.    The apparatus according to claim 1 characterized
in that said error compensating device is coupled serially
to the digital input of said digital to analog converter
device.

4.    The apparatus according to claim 1 characterized
in that said signal error compensating device comprises a
plurality of EXCLUSIVE OR gates operative to combine
selected ones of said digital input signal values into a
plurality of error correcting signals, each error
correcting signal corresponding to an orthonormal
component of signals produced by said digital to analog
converter device to be compensated, a weighting element,
and a digital adder, said weighting element for producing
said compensating signal, said weighting element
comprising a digital look-up table and a plurality of AND
gates, the selected outputs of said digital look-up table each being coupled through one AND gate with an output of a corresponding EXCLUSIVE OR gate to said digital adder, said digital adder being operative to generate said compensating signal.

5.    The apparatus according to claim 1 or 3 characterized in that said signal error compensating device comprises a plurality of EXCLUSIVE OR gates operative to combine selected ones of said digital input signal into a plurality of error correcting signals, each error correcting signal corresponding to an orthonormal component of signals produced by said digital to analog converter device to be compensated, a weighting element and a digital adder, said weighting element for producing said compensating signal, said weighting element comprising a digital look-up table coupled to receive output of said EXCLUSIVE OR gates and to supply said digital adder, said digital adder being operative to combine digital output values to generate said compensating signal.

6.    An apparatus for converting a digital input signal to an analog output signal charactered by:
          a digital to analog converter device having an analog signal conversion error for producing an analog intermediate signal, said conversion error being known in terms of orthonormal components of the input signal;
          an analog signal error compensating device responsive to said digital signal for producing an analog compensating signal specific to said conversion error and non-interacting with said digital to analog converter; and
          means for summing said analog intermediate signal and said analog compensating signal to produce said analog output signal.

7.    The apparatus according to claim 6 characterized in that said analog signal error compensating device is operative to decompose said digital input signal into orthogonal components and further including an EXCLUSIVE OR means for combining values representing selected ones of said orthogonal components into a single correcting signal for each combination of bits to be compensated, and at least one weighting element, each weighting element coupled to receive one said correcting signal for producing a component of said analog compensating signal.

8.    The apparatus according to claim 7 characterized in that each said weighting element is a resistor, said resistor being driven by the output of said corresponding EXCLUSIVE OR means.

9.    The apparatus according to claim 7 characterized in that said weighting element is a digital look-up table having individual outputs defining correction values, said digital look-up table being coupled through a combining network.

10.   The apparatus according to claim 6 characterized in that said error compensating device comprises a plurality of EXCLUSIVE OR gates operative to combine selected ones of said digital input signal values into a plurality of error correcting signals, each error correcting signal corresponding to an orthonormal component of signals produced by said digital to analog converter device to be compensated, a weighting element and a digital adder, said weighting element for producing said compensating signal, said weighting element comprising a digital look-up table and a plurality of AND gates, the selected outputs of said digital look-up table each being coupled through one AND gate with an output of a corresponding EXCLUSIVE OR gate to said digital adder, said digital adder being operative to generate said compensating signal, and further including a supplemental digital to analog converter, said supplemental digital to analog converter being coupled to receive the output of said digital adder for converting said digital compensating signal into an analog compensating signal, said analog compensating signal being applied to said summing means.

**FIG._1.**

f(y)=y−g(y)

**FIG._2.**

F(y)=g(y)
f(x)=G(x)

**FIG._3.**

f(z)=G(z)
F(y)=g(y)

**FIG._4.**

f(z)=G(z)−z

**FIG._5.**

0177653

2/2

FIG.__6.

FIG.__7.

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | IEEE INTERNATIONAL TEST CONFERENCE 1983 PROCEEDINGS, October 18-20, 1983, pages 598-605, paper 20.4, IEEE, New York, US; E.A. SLOANE et al.: "A general method for increasing converter accuracy and resolution" <br> * Page 598, column 1, line 24 - column 2, line 2; page 599, column 2, line 45 - page 600, column 2, line 21; page 601, column 2, lines 11-31; figures 3-5 * | 1-3,6-8 | H 03 M 1/06 |
| Y | Idem | 4-5,9-10 | |
| Y | ELECTRONICS LETTERS, vol. 14, no. 24, November 23rd, 1978, pages 790-791 and vol. 15, no. 5, March 1, 1979, page 166, "Errata", Hitchin, Herts, GB; J.R. STOCKTON et al.: "Some proposals for improved forms of precision fast digital-analogue and analogue-digital convertors" <br> * Page 790, column 2, lines 22-36; page 166, figure 1 * | 4-5,9-10 | TECHNICAL FIELDS SEARCHED (Int. Cl.4) <br><br> H 03 M |

The present search report has been drawn up for all claims

| Place of search | Date of completion of the search | Examiner |
|---|---|---|
| THE HAGUE | 20-06-1985 | BEINDORFF W.H. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503. 03.82